(19) Europäisches Patentamt

European Patent Office

Office européen des brevets

(11) **EP 0 737 003 B1**

(12) **FASCICULE DE BREVET EUROPEEN**

(45) Date de publication et mention
de la délivrance du brevet:
**14.08.2002 Bulletin 2002/33**

(51) Int Cl.⁷: **H04N 3/15**, H04N 5/335

(21) Numéro de dépôt: **96400711.6**

(22) Date de dépôt: **02.04.1996**

(54) **Amplificateur de lecture de registre CCD**

Ausleseverstärker für CCD-Register

CCD register readout amplifier

(84) Etats contractants désignés:
**AT BE CH DE FR GB IT LI NL SE**

(30) Priorité: **04.04.1995 FR 9503950**

(43) Date de publication de la demande:
**09.10.1996 Bulletin 1996/41**

(73) Titulaire: **Atmel Grenoble S.A.**
**38120 Saint-Egrève (FR)**

(72) Inventeur: **Cortiula, Jean Alain**
**92402 Courbevoie Cedex (FR)**

(74) Mandataire: **Guérin, Michel et al**
**Thomson-CSF Propriété Intellectuelle,**
**13, Avenue du Président Salvador Allende**
**94117 Arcueil Cédex (FR)**

(56) Documents cités:
**GB-A- 2 180 717      US-A- 4 710 725**
**US-A- 4 979 035**

**Description**

La présente invention concerne les registres de lecture utilisant le principe du transfert de charges et plus particulièrement le circuit de sortie de tels registres.

Les registres de lecture à transfert de charges sont utilisés, par exemple, dans les dispositifs photosensibles permettant de convertir une image lumineuse en charges électriques.

Le circuit de sortie d'un registre de lecture permet de convertir en signal électrique les charges transférées. Il est constitué d'une diode de lecture et d'un amplificateur de lecture. Des dispositifs de détection de charges sont décrits dans les brevets US 4 979 035, US 4 710 725 et GB 2 180 717.

Les applications nécessitant l'évacuation des charges à haut débit conduisent à multiplier les circuits de sortie pour un même registre. Comme cela est connu de l'homme de l'art, l'amplificateur de lecture de chaque sortie est généralement constitué de plusieurs étages d'amplification montés en série. Les courants de polarisation des étages d'amplification successifs ont alors des valeurs croissantes. A titre d'exemple, un amplificateur de lecture constitué de 3 étages d'amplification peut alors avoir à fournir un courant de l'ordre de 15 mA sous une tension de 15 volts. Il n'est alors pas possible de multiplier le nombre de sorties comme cela serait souhaitable car la puissance que devrait dissiper le registre de lecture atteindrait alors rapidement des valeurs trop élevées. Par exemple, un registre de lecture de 32 sorties ayant chacune un amplificateur de lecture polarisé comme mentionné ci-dessus (15 mA, 15 volts) n'est pas réalisable car cela conduirait à une puissance dissipée dans le registre de l'ordre de 7 watts.

L'invention ne présente pas cet inconvénient.

L'invention concerne un dispositif de conversion charges-tension de registre de lecture à transfert de charges comprenant une diode de lecture et un amplificateur de lecture comportant un premier étage d'amplification comprenant un transistor MOS dont la grille est reliée à une première borne de la diode de lecture dont l'autre borne est reliée à la masse du dispositif et un deuxième étage d'amplification, caractérisé en ce que le deuxième étage d'amplification est un amplificateur de type base commune ayant un transistor bipolaire dont l'émetteur est relié à la source du transistor MOS, le premier étage permettant de convertir en variations de courant, à tension sensiblement constante, les variations de tension recueillies aux bornes de la diode de lecture, le deuxième étage d'amplification permettant de faire une lecture desdites variations de courant, du premier étage.

Un avantage de l'invention est de permettre une diminution significative de la puissance dissipée dans le registre de lecture.

D'autres caractéristiques et avantages de l'invention apparaîtront à la lecture d'un mode de réalisation préférentiel fait avec référence aux figures ci-annexées parmi lesquelles :

- la figure 1 représente un circuit de sortie de registre de lecture selon l'art antérieur,
- la figure 2 représente un circuit de sortie de registre de lecture selon l'invention.

Sur toutes les figures, les mêmes repères désignent les mêmes éléments.

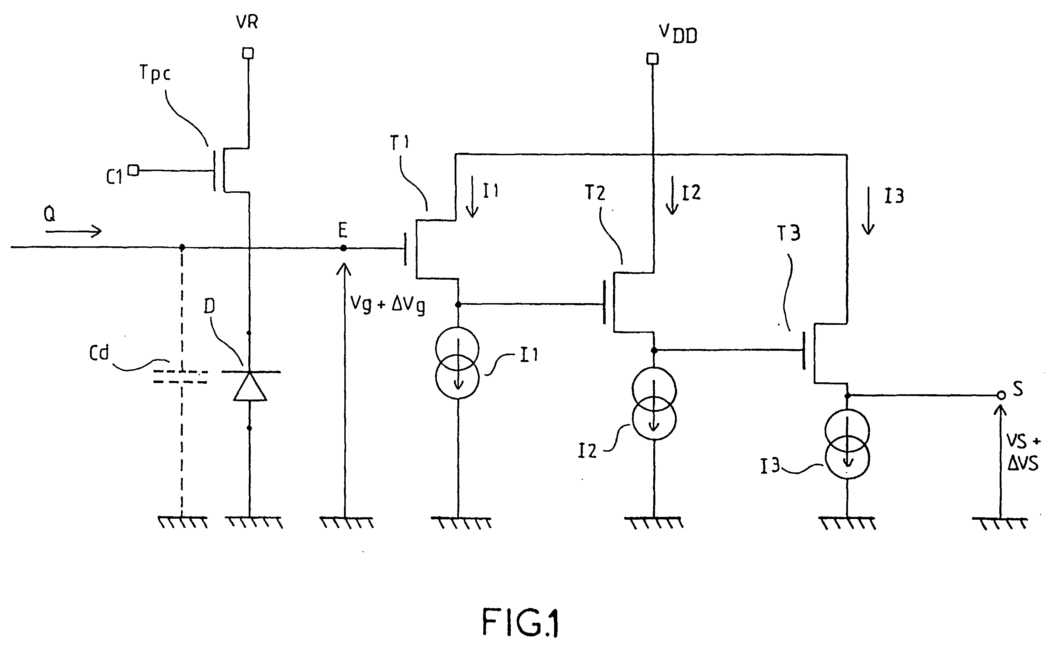

La figure 1 représente un circuit de sortie de registre de lecture selon l'art antérieur.

Le circuit de sortie permet la conversion de la charge Q issue d'une grille de stockage (non représentée sur la figure) en une tension Vs recueillie en sortie S du registre à décalage.

Comme cela a été mentionné précédemment, le circuit de sortie est constitué d'une diode de lecture et d'un amplificateur de lecture. Un transistor MOS Tpc effectue, sous l'effet de la commande C1 appliquée à sa grille, une précharge de la capacité Cd (représentée en traits pointillés sur la figure 1) de la diode D avant l'arrivée de la charge Q. Le transistor Tpc a son drain relié à une tension d'alimentation VR et sa source reliée à la fois au point d'arrivée de la charge Q, à la cathode de la diode D et à l'entrée E de l'amplificateur de lecture.

Dans l'exemple choisi, l'amplificateur de lecture est constitué de 3 étages d'amplification successifs. Chaque étage d'amplification est constitué d'un transistor MOS dont le drain est relié à une tension d'alimentation VDD et la source à la première borne d'un générateur de courant dont l'autre borne est reliée à la masse du circuit. Le premier étage d'amplification est ainsi constitué d'un transistor T1 et d'un générateur de courant I1, le deuxième étage d'un transistor T2 et d'un générateur de courant I2 et le troisième étage d'un transistor T3 et d'un générateur de courant I3. La source du transistor T1 est reliée à la grille du transistor T2 et la source du transistor T2 est reliée à la grille du transistor T3. L'entrée E de l'amplificateur de lecture est la grille du transistor T1. La sortie S de l'amplificateur de lecture est la source du transistor T3. Comme cela a été mentionné précédemment, les courants I1, I2 et I3 ont des valeurs croissantes. A titre d'exemple le courant I1 peut être égal à 0,5 mA, le courant I2 à 1 ou 2 mA et le courant I3 à 12 ou 13 mA. Il s'en suit que la somme des courants I1 + I2 + I3 peut atteindre une valeur de l'ordre de 15 mA. Pour une tension d'alimentation VDD égale à 15 V, la puissance dissipée par le circuit de sortie atteint alors une valeur de l'ordre de 0,23 watt. Il n'est alors pas possible de multiplier en trop grand nombre les circuits de sortie d'un même registre de lecture sous peine d'atteindre des valeurs de puissance dissipée trop élevées. A titre d'exemple, il n'est pas possible de concevoir un registre de lecture ayant 32 sorties car la puissance dissipée dans le registre atteindrait alors une valeur sensiblement égale à 7 watts.

Un autre inconvénient de la multiplication des étages d'amplification selon l'art antérieur est l'obtention de facteur de conversion de faible valeur. Comme cela est connu de l'homme de l'art, le facteur de conversion qui relie la tension de sortie du convertisseur à la charge recueillie est donnée par la formule $F_c = \frac{G}{Cd}$ ou Cd est la capacité de la diode définie précédemment et G le gain de l'amplificateur de lecture.

Selon l'art antérieur, chaque étage d'amplification a un gain de valeur inférieure à 1, par exemple de l'ordre de 0,85. Il s'en suit que le gain global G de l'amplificateur de lecture est d'autant plus faible que le nombre d'étages d'amplification est élevé. Dans l'exemple choisi ci-dessus, l'amplificateur de lecture est constitué de 3 étages d'amplification. Le gain G vaut alors sensiblement 0,6. L'amplificateur de lecture selon l'invention ne présente pas cet inconvénient. Comme cela apparaîtra ultérieurement le circuit de sortie selon l'invention permet avantageusement d'obtenir des facteurs de conversion de valeurs plus élevées que les circuits de sortie de l'art antérieur.

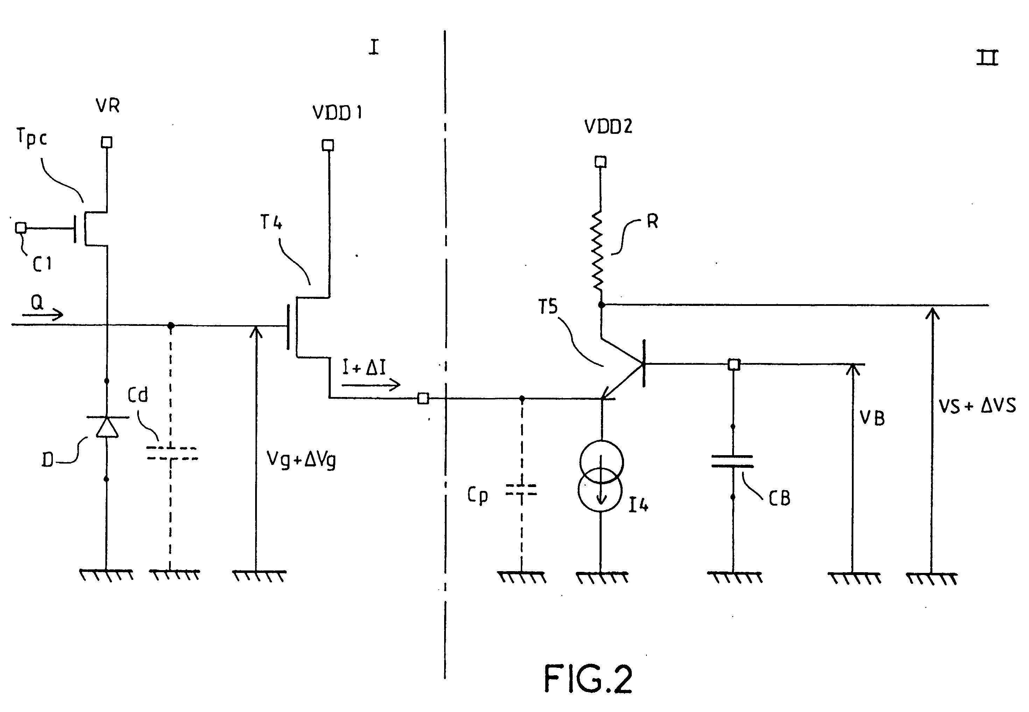

La figure 2 représente un circuit de sortie de registre de lecture selon l'invention.

La figure 2 est divisée en deux zones. Les éléments situés dans la zone I sont intégrés au registre de lecture et les éléments situés dans la zone II sont extérieurs au registre de lecture. Les éléments situés dans la la zone II sont alors soit des composants discrets soit des composants intégrés sur une même puce.

Dans la zone I sont situés la diode de lecture D et le transistor MOS Tpc qui a pour fonction de permettre la précharge de la capacité Cd de la diode D avant l'arrivée de la charge Q. De même que selon l'art antérieur, le transistor Tpc est, par exemple, un transistor MOS de type N dont le drain est relié à une tension d'alimentation VR et dont la source est reliée à la fois au point d'arrivée de la charge Q et à la cathode de la diode D dont l'anode est reliée à la masse.

Selon l'invention, l'amplificateur de lecture comporte un premier étage d'amplification comprenant un transistor MOS permettant de convertir en variations de courant, à tension sensiblement constante, les variations de tension recueillies aux bornes de la diode de lecture et un deuxième étage d'amplification de type base commune permettant de faire une lecture desdites variations de courant, du premier étage.

Selon le mode de réalisation préférentiel de l'invention, le premier étage d'amplification est réalisé à l'aide d'un transistor MOS T4 de type N intégré au registre de lecture. Le transistor MOS T4 de type N a sa grille reliée à la cathode de la diode D et son drain relié à une tension d'alimentation VDD1. La source du transistor T4 constitue la sortie du registre de lecture.

L'étage de lecture en courant est préférentiellement un amplificateur de type base commune constitué d'un transistor bipolaire, de type NPN, dont la base est reliée à la masse par l'intermédiaire dune capacité CB, dont l'émetteur est relié à la source du transistor T4 et à la masse du circuit par l'intermédiaire d'un générateur de courant 14 et dont le collecteur est relié à une tension d'alimentation VDD2, par exemple égale à 15 volts, par l'intermédiaire dune résistance R. La valeur du courant 14 peut, par exemple, être égale à 3 mA. La valeur de la capacité CB est choisie de façon à assurer le montage de type base commune du transistor T5. A titre d'exemple cette valeur peut être égale à 100 nF. Pour certaines applications, telles que celles exigeant d'excellentes performances de bruit, le générateur de courant 14 peut être remplacé par une résistance.

Une tension VB est appliquée sur la base du transistor bipolaire T5 de façon à rendre celui-ci passant et à fixer la tension drain-source du transistor T4. A titre d'exemple, la tension VB peut être égale à 7 volts. Le courant de polarisation du transistor T4 peut alors avoir une valeur comprise, par exemple, entre 1 et 3 mA.

La lecture des charges aux bornes de la diode D se traduit par une variation $\Delta Vg$ de la tension Vg qui est appliquée sur la grille du transistor T4. Il s'en suit une variation $\Delta I$ du courant qui parcourt le transistor T4. Cette variation $\Delta I$ est donnée par la formule : $\Delta I = gm$ $\Delta Vg$ ou gm est la transconductance du transistor T4. A titre d'exemple, la géométrie du transistor T4 peut être choisie de façon que gm soit égal à 0,5 mS.

La tension de sortie VS de l'amplificateur de lecture est prise entre le collecteur du transistor T5 et la masse du circuit. La variation $\Delta Vs$ de la tension VS s'écrit :

$$\Delta VS = R \, \Delta I$$

Comme cela a été mentionné précédemment, le courant 14 a une valeur de quelques mA, par exemple 3 mA, alors que la somme des courants I1 + 12 + 13 du dispositif de l'art antérieur atteint 15 mA. Avantageusement, l'invention permet donc de réduire considérablement la consommation de l'amplificateur de lecture et, partant, la puissance dissipée dans le registre de lecture.

Avantageusement, la puissance dissipée dans le registre de lecture selon l'invention est aussi réduite du fait de la diminution de la tension d'alimentation VDD1 par rapport à la tension VDD.

Selon l'art antérieur, les variations de tension recueillies aux bornes de la diode entraînent des variations de la tension drain-source des transistors constituant l'amplificateur de lecture. Il est donc nécessaire que la tension d'alimentation VDD soit suffisamment élevée, par exemple égale à 15 volts, pour assurer une polarisation correcte des transistors T1, T2 et T3.

Selon l'invention, le premier étage d'amplification de l'amplificateur de lecture convertit les variations de tension recueillies aux bornes de la diode en variation de courant. La tension drain-source du transistor T4 demeure sensiblement constante. Il n'est alors pas nécessaire que la tension VDD1 ait une valeur aussi élevée que la tension VDD. A titre d'exemple, la tension VDD1 peut être choisie égale à 13 volts.

La puissance consommée par un amplificateur de lecture selon l'invention peut alors être divisée, par exemple, par un facteur de l'ordre de 10 par rapport à la puissance consommée par un amplificateur de lecture selon l'art antérieur. Un registre de lecture comprenant, par exemple, 32 sorties est alors réalisable.

Un autre avantage de la lecture en courant selon l'invention consiste à éliminer l'influence de la capacité parasite Cp (représentée en traits pointillés sur la figure 2) qui résulte de la connexion entre le registre de lecture et le circuit de charge extérieur au registre de lecture.

Avantageusement, l'amplificateur de type base commune présente une impédance d'entrée de valeur suffisamment faible pour court-circuiter la capacité Cp. Il s'en suit que le courant lu n'est pas affecté par la présence de cette capacité. Dans les dispositifs de l'art antérieur, par contre, la capacité Cp ne peut pas être négligée devant l'impédance d'entrée du circuit extérieur au registre de lecture. L'influence de la capacité Cp conduit alors à détériorer la bande passante du convertisseur charges-tension.

Avantageusement l'invention ne présente pas cet inconvénient et il est alors possible, par exemple, d'atteindre des valeurs de bande passante de l'ordre de 240 MHz.

Un autre avantage du circuit de sortie selon l'invention est de permettre l'ajustage du facteur de conversion Fc qui relie la variation $\Delta$Vs de la tension de sortie à la charge recueillie $\Delta$Q.

Le facteur de conversion s'écrit en effet :

$$F_c = \frac{\Delta VS}{\Delta Q}$$

or $\Delta Q = Cd\,\Delta Vg$, $\Delta V_g = \frac{\Delta I}{gm}$ et $\Delta VS = R\Delta I$.

il vient donc :

$$F_c = R\frac{gm}{Cd}$$

La modification de la résistance R permet alors avantageusement de faire varier le facteur de conversion Fc.

La fréquence de coupure de la bande passante du circuit de conversion charge-tension est donnée par la formula

$$f = \frac{1}{2\pi RC_o}$$

où R est la résistance définie ci-dessus et $C_o$ la capacité environnante (non représentée sur la figure) au niveau collecteur du transistor T5.

Alors que le facteur de conversion $F_c$ est proportionnel à R, la fréquence de coupure f de la bande passante est inversement proportionnelle à R. Il s'en suit que pour des applications mettant en oeuvre des fréquences de coupure relativement basses, le facteur de conversion peut atteindre des valeurs avantageusement élevées.

A titre d'exemple, il est alors possible d'atteindre un facteur de conversion de l'ordre de 16 µV par électron pour une bande passante de l'ordre de quelques MHz.

Selon le mode de réalisation préférentiel décrit ci-dessus le premier étage d'amplification de l'amplificateur de lecture est réalisé par un transistor MOS de type N et le deuxième étage d'amplification par un transistor bipolaire de type NPN.

L'invention concerne cependant d'autres modes de réalisation comme par exemple celui où le premier étage d'amplification est réalisé par un transistor MOS de type P et le deuxième étage d'amplification par un transistor bipolaire de type PNP. C'est alors l'anode et non plus la cathode de la diode D qui est reliée à la grille du transistor MOS T4. De même, l'étage de lecture en courant peut être réalisé par tout dispositif connu de lecture en courant.

**Revendications**

1. Dispositif de conversion charges-tension de registre de lecture à transfert de charges comprenant une diode (D) de lecture et un amplificateur de lecture comportant un premier étage d'amplification comprenant un transistor MOS (T4) dont la grille est reliée à une première borne de la diode (D) de lecture dont fautre borne est reliée à la masse du dispositif et un deuxième étage d'amplification, **caractérisé en ce que** le deuxième étage d'amplification est un amplificateur de type base commune ayant un transistor bipolaire (T5) dont l'émetteur est relié à la source du transistor MOS(T4), le premier étage permettant de convertir en variations de courant ($\Delta$I), à tension sensiblement constante, les variations de tension ($\Delta$ Vg) recueillies aux bornes de la diode (D) de lecture, le deuxième étage d'amplification permettant de faire une lecture desdites variations de courant du premier étage.

2. Dispositif selon la revendication 1, **caractérisé en ce que** la base du transistor bipolaire (T5) est reliée à la masse du dispositif par l'intermédiaire d'une capacité (CB), ladite base étant reliée à une tension (VB) réglée de façon à rendre ledit transistor bipolaire (T5) passant, dont l'émetteur est relié à une première borne d'un générateur de courant (I4) dont la deuxième borne est reliée à la masse du dispositif, et dont le collecteur qui représente la sortie (S) de l'amplificateur de lecture, est relié à une tension d'alimentation (VDD2) par l'intermédiaire d'une résistance (R).

**3.** Dispositif selon l'une des revendications 1 ou 2, **caractérisé en ce que** le transistor MOS (T4) est un transistor de type N, **en ce que** la première borne de la diode (D) de lecture est la cathode de ladite diode et **en ce que** le transistor bipolaire (T5) est un transistor de type NPN.

**4.** Dispositif selon l'une des revendications 1 ou 2, **caractérisé en ce que** le transistor MOS (T4) est un transistor de type P, **en ce que** la première borne de la diode (D) de lecture est l'anode de ladite diode et **en ce que** le transistor bipolaire (T5) est un transistor de type PNP.

**Patentansprüche**

**1.** Vorrichtung zur Ladungs/Spannungs-Umsetzung von Ladungsverschiebungs-Leseregistern, mit einer Lesediode (D) und einem Leseverstärker, der eine erste Verstärkungsstufe, die einen MOS-Transistor (T4) enthält, dessen Gate mit einem ersten Anschluß der Lesediode (D) verbunden ist und dessen anderer Anschluß mit der Masse der Vorrichtung verbunden ist, und eine zweite Verstärkungsstufe umfaßt, **dadurch gekennzeichnet, daß** die zweite Verstärkungsstufe ein Verstärker des Typs mit gemeinsamer Basis ist, der einen Bipolartransistor (T5) besitzt, dessen Emitter mit der Source des MOS-Transistors (T4) verbunden ist, wobei die erste Stufe ermöglicht, die Spannungsänderungen ($\Delta$Vg), die an den Anschlüssen der Lesediode (D) aufgenommen werden, in Stromänderungen ($\Delta$I) mit im wesentlichen konstanter Spannung umzusetzen, und die zweite Verstärkungsstufe ermöglicht, ein Lesen der Änderungen des Stroms der ersten Stufe auszuführen.

**2.** Vorrichtung nach Anspruch 1, **dadurch gekennzeichnet, daß** die Basis des Bipolartransistors (T5) mit der Masse der Vorrichtung über eine Kapazität (CB) verbunden ist, wobei die Basis mit einer Spannung (VB) verbunden ist, die in der Weise geregelt wird, daß der Bipolartransistor (T5) durchschaltet, dessen Emitter mit einem ersten Anschluß eines Stromgenerators (I4) verbunden ist, dessen zweiter Anschluß mit der Masse der Vorrichtung verbunden ist, und dessen Kollektor, der den Ausgang (S) des Leseverstärkers bildet, über einen Widerstand (R) mit einer Versorgungsspannung (VDD2) verbunden ist.

**3.** Vorrichtung nach einem der Ansprüche 1 oder 2, **dadurch gekennzeichnet, daß** der MOS-Transistor (T4) ein N-Transistor ist, daß der erste Anschluß der Lesediode (D) die Katode der Diode ist und daß der Bipolartransistor (T5) ein NPN-Transistor ist.

**4.** Vorrichtung nach einem der Ansprüche 1 oder 2, **dadurch gekennzeichnet, daß** der MOS-Transistor (T4) ein P-Transistor ist, daß der erste Anschluß der Lesediode (D) die Anode der Diode ist und daß der Bipolartransistor (T5) ein PNP-Transistor ist.

**Claims**

**1.** Charge-transfer read register charge/voltage conversion device comprising a read diode (D) and a read amplifier having a first amplification stage comprising a MOS transistor (T4) whose gate is connected to a first terminal of the read diode (D), the other terminal of which is connected to the ground of the device and a second amplification stage, **characterized in that** the second amplification stage is an amplifier of common base type having a bipolar transistor (T5) whose emitter is connected to the source of the MOS transistor (T4), the first stage enabling the conversion, into current variations ($\Delta$I), at substantially constant voltage, of the voltage variations ($\Delta$Vg) gathered at the terminals of the read diode (D), the second amplification stage making it possible to read the said current variations of the first stage.

**2.** Device according to Claim 1, **characterized in that** the base of the bipolar transistor (T5) is connected to the ground of the device by way of a capacitor (CB), the said base being connected to a voltage (VB) adjusted so as to turn the said bipolar transistor (T5) on, the emitter of which is connected to a first terminal of a current generator (I4) whose second terminal is connected to the ground of the device, and whose collector which represents the output (S) of the read amplifier, is connected to a supply voltage (VDD2) by way of a resistor (R).

**3.** Device according to one of Claims 1 or 2, **characterized in that** the MOS transistor (T4) is an N type transistor, **in that** the first terminal of the read diode (D) is the cathode of the said diode and **in that** the bipolar transistor (T5) is an NPN type transistor.

**4.** Device according to one of Claims 1 or 2, **characterized in that** the MOS transistor (T4) is a P type transistor, **in that** the first terminal of the read diode (D) is the anode of the said diode and **in that** the bipolar transistor (T5) is a PNP type transistor.

FIG.1

FIG.2